# EUROPEAN PATENT APPLICATION

(11) **EP 3 525 250 A2**
(43) Date of publication of application: **14.08.2019**
(21) Application number: 19152361.2
(22) Date of filing: 17.01.2019
(51) Int. Cl.: H01L 35/28, H01L 35/00

(54) **A MICRO COGENERATION SYSTEM**

(30) Priority: 18.01.2018 GB 201800807
(71) Applicant: Exergit Ltd, London WC2H 9JQ (GB)
(72) Inventor: FRASCATI, Marco, London, SW8 4RP (GB); PELIZZARI, Andrea, London, SE8 5AJ (GB)
(74) Representative: Boult Wade Tennant LLP

(57) **Abstract**

A micro cogeneration system is provided, comprising a water inlet for receiving cold water; a water outlet for outputting hot water; a conduit connecting the water inlet and outlet; a fuel supply line for supplying combustible fuel; and a combustion chamber. The combustion chamber surrounds a burner, the burner arranged to burn combustible fuel delivered by the fuel supply line to generate heat for heating water in the conduit. The micro cogeneration system further comprises a flue passageway arranged to receive heated gas from the combustion chamber; one or more thermoelectric generator modules arranged to generate electricity from the heat generated in the combustion chamber, comprising a hot side with a hot contact surface arranged to receive heat from the combustion chamber, and a cold side with a cold contact surface arranged to transfer heat to a first section of the conduit; and a heat exchanger arranged to transfer heat from the flue passageway to a second section of the conduit, the second section of the conduit being downstream of the first section of the conduit.

## Description

The present invention relates to a micro cogeneration system for use in a domestic environment. Cogeneration, also known as combined heat and power (CHP), is the use of a heat engine or power station to generate electricity and useful heat at the same time. A micro system (micro CHP) is an extension of this idea to a single building, or a small group of buildings, such as a home or small office. Typically such systems generate in the range of up to 5 kWe.

This idea of installing micro CHP devices in domestic environments to save money by generating electricity as a by-product of heating the property has been considered a disruptive progress in the last decade. Even if from a technical point of view micro cogeneration is viable, uptake has been slow. This is due at least in part to the high prices of the existent technologies.

Typically, known micro CHP systems rely on innovative technologies, require additional complex moving parts, and/or require additional heavy components which are not easy to be installed in a domestic boiler system. As a result, the initial installation costs and/or typical operating costs are significantly higher than a standard condensing boiler.

Standard condensing boiler cases have a width of approximately 430 mm, a height of approximately 750 mm, and a depth of approximately 350 mm. This provides a useable volume in the region of 0.2 m³ for a total weight of no more than 60 kg.

In a particular type of micro CHP system, one or more thermoelectric generators (TEGs), also known as Seebeck generators, are provided to generate electricity from the temperature differentials within heat exchangers. A TEG is a solid-state device that has a hot side and a cold side, and converts heat flux (temperature difference) across these sides directly into electrical energy through the Seebeck effect.

US 2014/0020730 A1 discloses a CHP system for a residential household or group of households. This system is primarily designed for the American market, where residential condensing boilers are not widespread in the same manner as in Europe. A physically large system is provided, with TEGs and their associated coolant channels greatly increasing the physical dimensions of the combustion chamber. This system is to be typically installed outside the house.

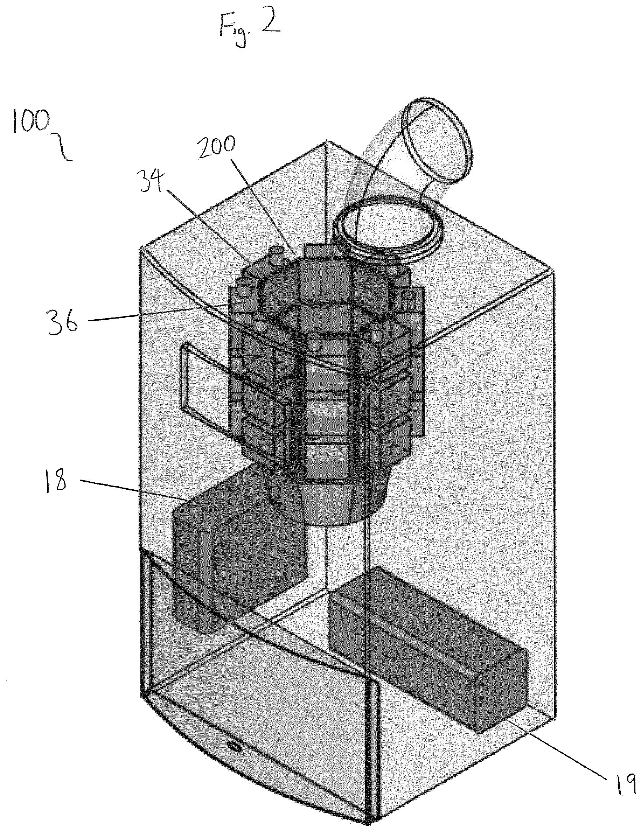

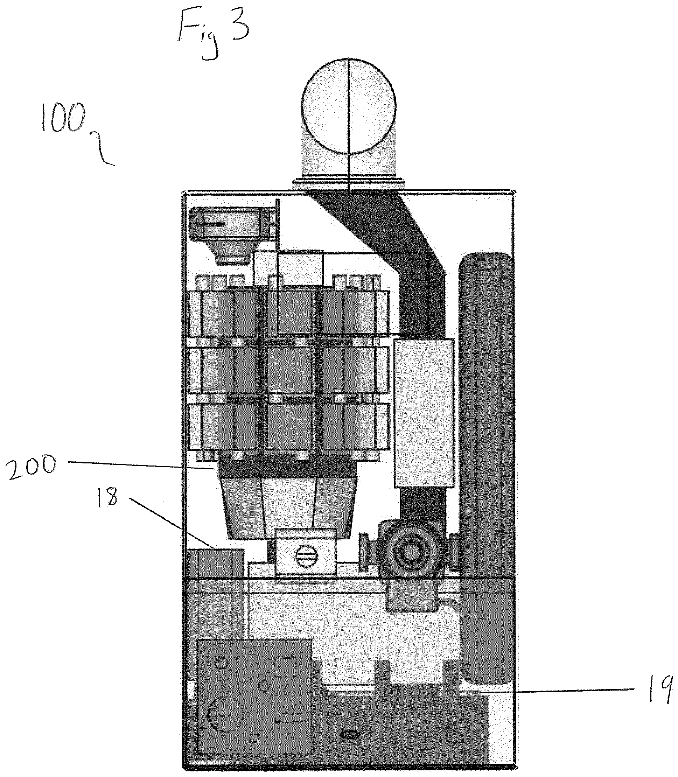

Figure 2B of US 2014/0020730 A1 depicts the TEGs, without their coolant channels, as having an effective width of 16 inches (406.4 mm). As can be seen in Figure 3B, the coolant channels are typically thicker than the TEGs. As such, the total width of the combustion chamber, TEGs, and coolant channel(s) of the embodiment of Figure 2B is likely to be greater than 20 inches (508 mm), as each TEG in 2B has a width of 2 inches (50.8 mm).

KR 101612897 B discloses a micro CHP system with a series of boilers providing progressively lower grade heat. Oil is heated by the medium grade boiler and suppled to the hot side of a TEG system. The cold side of the TEG is supplied by water returned from the home heating system, before the water is progressively heated by the series of boilers. Again, this system is physically large and the series of boilers makes this difficult to retrofit in existing boiler systems.

There is therefore a need for a micro CHP system which can be easily fitted into typical boiler casings, and which efficiently uses TEGs to generate electricity.

A micro cogeneration system according to the present invention is provided according to claim 1. This comprises a water inlet for receiving cold water; a water outlet for outputting hot water; a conduit connecting the water inlet and outlet; a fuel supply line for supplying combustible fuel; a combustion chamber, the combustion chamber surrounding a burner, the burner arranged to burn combustible fuel delivered by the fuel supply line to generate heat for heating water in the conduit; a flue passageway arranged to receive heated gas from the combustion chamber one or more thermoelectric generator modules arranged to generate electricity from the heat generated in the combustion chamber, comprising a hot side with a hot contact surface arranged to receive heat from the combustion chamber, and a cold side with a cold contact surface arranged to transfer heat to a first section of the conduit; and a heat exchanger arranged to transfer heat from the flue passageway to a second section of the conduit, the second section of the conduit being downstream of the first section of the conduit.

This arrangement allows the system size to be minimized, while delivering high grade heat to the thermoelectric generator modules. As a result, heat and power can be generated by a system fitting within a standard boiler case.

The or each thermoelectric generator modules may comprise a heat sink for transferring heat to the first section of the conduit.

The system may comprise a first plurality of thermoelectric generator modules, and the heat sinks of each of the first plurality of thermoelectric generator modules may be fluidly connected to form a heat sink conduit for flow of a fluid medium. Connecting the heat sinks allows a graduation of temperature to be set-up which can be tuned for efficiency.

The heat sink conduit may form a tortuous pathway. This ensures a longer contact time between the fluid medium and the cold contact of the TEG to encourage heat transfer.

The first plurality of thermoelectric generator modules may be arranged in a substantially vertical stack in use.

The system may further comprise a second plurality of thermoelectric generator modules, and the heat sinks of each of the second plurality of thermoelectric generator modules may be fluidly connected to form a second heat sink conduit for flow of a fluid medium in parallel to the first conduit. Connecting the heat sinks allows a graduation of temperature to be set-up which can be tuned for efficiency.

The second heat sink conduit may form a tortuous pathway. This ensures a longer contact time between the fluid medium and the cold contact of the TEG to encourage heat transfer.

The second plurality of thermoelectric generator modules may be arranged in a substantially vertical stack in use.

The combustion chamber may be at least partially bounded by the hot contact surface of one or more of the thermoelectric generator modules. By having the hot contact directly bounding the combustion chamber, the efficiency of the system can be maximised.

The system may further comprise one or more frames for supporting one or more thermoelectric generator modules.

Each thermoelectric generator module may comprise a frame for attaching to a further thermoelectric generator module. This allows each module to be individually attachable for easy manufacture.

A single central frame may be provided onto which each thermoelectric generator module is attached. The central frame imparts additional stability to the structure.

The frame may be substantially on the hot side of the thermoelectric generator module.

The frame may surround or overlay a periphery of the hot contact surface.

The frame and the hot contact surface may collectively define a hot side surface area, wherein the hot contact surface is at least 80% of this surface area.

The burner may be a cylindrical burner configured to optimise the system for radiative heat exchange.

The micro cogeneration system may further comprise a control system in electrical connection with the one or more thermoelectric generator modules for measuring characteristics of electricity generated by the one or more thermoelectric generator modules, wherein the control system is configured to use these characteristics to determine properties of one or more of: exhaust flue gasses; a fluid coolant medium, wherein the properties include temperature.

The heat exchanger may be a counter-current heat exchanger.

The micro cogeneration system may further comprise a condenser upstream of the first section of the conduit for condensing water entering the system, the condenser being downstream of the flue passageway for the flue gas.

A micro cogeneration system, is provided according to a second embodiment of the present invention according to claim 11. This system comprises: a housing; a water inlet into the housing for receiving cold water; a water outlet from the housing for outputting hot water; a conduit within the housing connecting the water inlet and outlet; a fuel supply line for supplying combustible fuel; a combustion chamber within the housing, the combustion chamber surrounding a burner, the burner arranged to burn combustible fuel delivered by the fuel supply line to generate heat for heating water in the conduit; one or more thermoelectric generator modules comprising: a heat sink; and a thermoelectric generator having a hot side having a hot contact surface arranged to receive heat from the combustion chamber, and a cold side having a cold contact surface arranged to transfer heat to a heat sink, wherein the combustion chamber and thermoelectric generator modules have a combined effective width, which is less than 450 mm.

Preferably, the combustion chamber and thermoelectric generator modules have a combined effective width of no more than 375 mm, and more preferably no more than 350 mm.

These dimensions allow the system to be retrofitted within an existing boiler casing.

A method of replacing a condensing boiler comprising a condenser and a boiler housing, with a micro cogeneration system, according to the present invention is provided according to claim 13. The method comprising the steps of: removing the combustion chamber of the condensing boiler; installing within the boiler housing a new combustion chamber, with one or more thermoelectric generator modules arranged to generate electricity from the heat generated in the combustion chamber, comprising a hot side with a hot contact surface arranged to receive heat from the combustion chamber, and a cold side with a cold contact surface; and re-routing a water outlet of the condenser to pass through one or more conduits arranged to receive heat from the cold contact surface of the one or more thermoelectric generator modules.

A method of replacing a non-condensing boiler comprising a boiler housing, with a micro cogeneration system, according to the present invention is provided according to claim 14. The method comprising the steps of: removing the combustion chamber of the non-condensing boiler; installing within the boiler housing a new combustion chamber, with one or more thermoelectric generator modules arranged to generate electricity from the heat generated in the combustion chamber, comprising a hot side with a hot contact surface arranged to receive heat from the combustion chamber, and a cold side with a cold contact surface; installing a condenser to transfer heat from flue gasses to a water inlet to the boiler; installing a condensate drain configured to discharge condensate; and routing a water outlet of the condenser to pass through one or more conduits arranged to receive heat from the cold contact surface of the one or more thermoelectric generator modules.

Each of these methods allows a micro CHP system to be installed within a user's existing domestic boiler housing.

Preferably, either method further comprises the step of installing a dedicated electric circuit configured to receive electricity from the one or more thermoelectric generator modules.

This allows the system to reliably deliver power back to the household system from the thermoelectric generators.

The present invention will now be described with reference to the accompanying Figures, in which:
Figure 1 is a perspective view of a micro CHP system according to the present invention;
Figure 2 is a perspective view of the micro CHP system of Figure 1, with only the additional features over a standard condensing boiler shown;
Figure 3 is a front view of the micro CHP system of Figure 1;
Figure 4 is a front perspective view of the combustion chamber, TEG module, and heat sink assembly of Figure 1;
Figure 5 is a side view of a single TEG module and heat sink assembly of Figure 4;
Figure 6 is a front schematic view of a micro CHP system according to the present invention;
Figure 7 is a front schematic view of the system of Figure 6, showing the flow pathways therethrough; and
Figure 8 is a schematic of a domestic household using the micro CHP system of Figure 1.

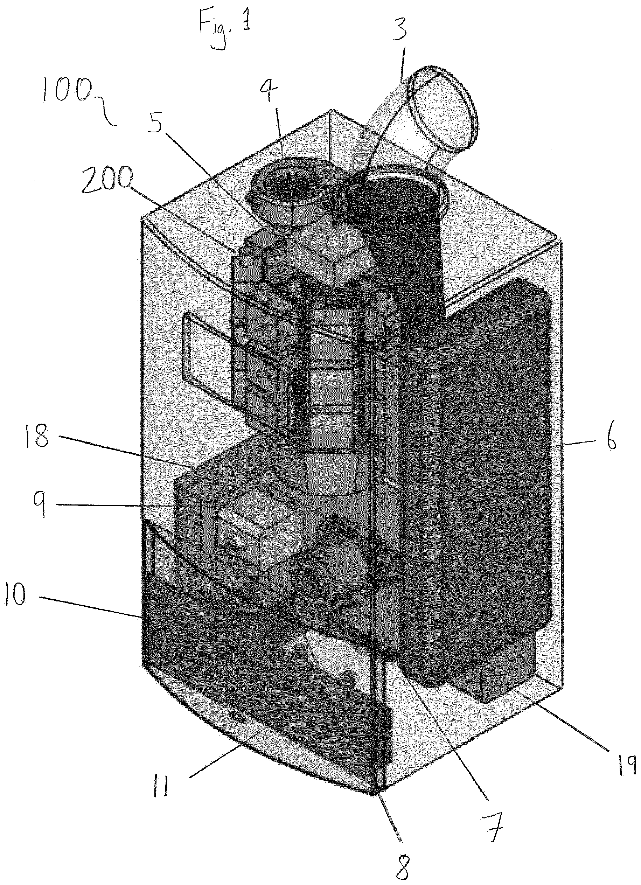

Figure 1 depicts a perspective view of a micro CHP system 100, with the known components of Figure 1 hidden in Figure 2.

The present system is designed to be fitted into an existing gas boiler casing. As such, a number of the conventional boiler components are arranged to operate in a standard manner within the new system. In particular, the flue pipe 3, burner fan 4, gas regulation system 5, expansion vessel 6, circulation pump 7, DHW heat exchanger 8, gas safety valve 9, electronic circuitry 10 and water/gas connections 11 as shown in Figure 1 are arranged and configured to operate in their usual manner.

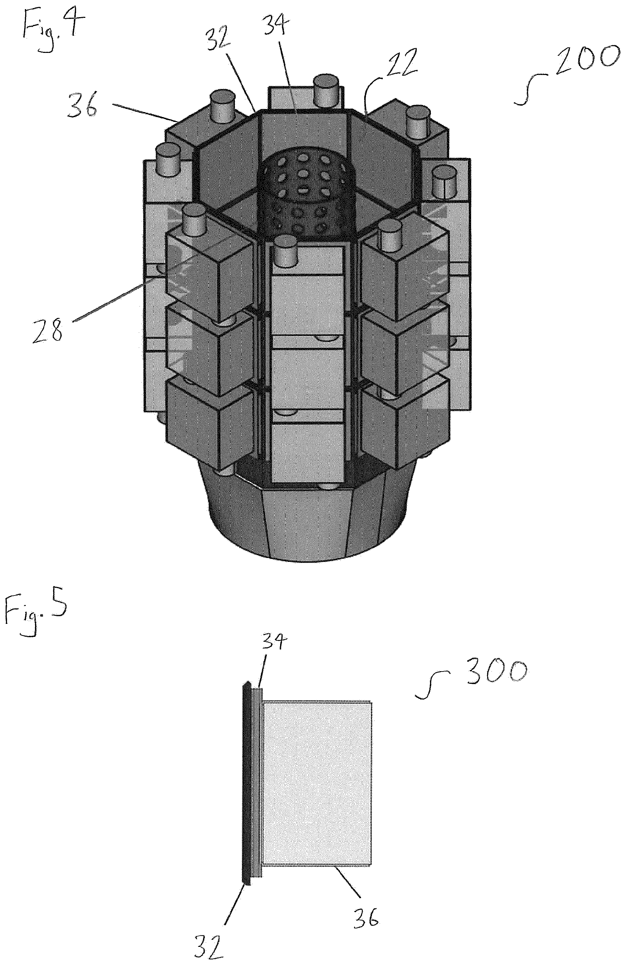

The traditional primary heat exchanger of a condensing boiler is replaced in the micro CHP system 100 with the heat exchanger construction 200. This construction 200 is described in detail below with respect to Figure 4. An electric and electronic control box 18 is provided, along with a DC-AC inverter 19.

The DC-AC inverter 19 converts the direct current generated by the TEGS 34 into an alternating current for use in the normal household electrical system. DC-DC boosters (not shown) may also be provided for equalising and rising the tension level of each TEG module in the system 100.

The control box 18 includes the control circuitry for operating the system, including typical switches and fuses for ensuring electrical safety during micro CHP operation.

The control box 18 may include so-called "*smart*" controllers, which act to regulate micro CHP operation based upon measured or predicted variables, such as the outside weather and temperature, and/or a predicted energy demand. A smart thermostat may also be provided to efficiently control the system 100 based upon the current temperature in rooms and measurements and/or predictions of their occupancy.

A "*smart*" meter may be connected to the control circuitry in order to provide a reading of the electricity generated by the micro CHP unit.

The heat exchanger construction 200 is formed as shown in Figure 4. A combustion chamber 22 is formed from a plurality of TEG assemblies 300, as shown in Figure 5. The TEG assemblies 300 are provided in a plurality of vertical stacks in the depicted embodiment.

Each TEG assembly 300 is formed of a frame member 32, a high temperature TEG 34 and a heat sink 36. The TEG 34 has a hot side facing towards the frame member 32, and a cold side in contact with the heat sink 36. The hot side has a hot contact surface, and the cold side has a cold contact surface. The contact surfaces are for receiving and transferring heat respectively.

In the depicted embodiment, each frame member 32 substantially surrounds the periphery of the hot contact surface of the TEG 34. However, any suitable frame structure which allows the TEG assemblies 300 to be attached to one another and/or a central frame to form the heat exchanger construction 200 may be used.

In particular other embodiments, one frame member may support multiple TEGs 34. For example, each vertical stack may comprise one frame member and a plurality of TEGs 34, with a plurality of such vertical stack frame members forming the combustion chamber 22. Alternatively, a ring frame member may be provided, with a horizontal stack of TEGs 34.

Alternatively, a single central frame member may form a 3D frame structure for all of the TEGs 34 in to the system to attach to, thereby forming the combustion chamber 22.

This frame member 32 and/or central frame is designed to be as thin as possible as the hot contact surface of the TEGs 34 is attached thereto, This allows the maximum heat to be transferred to the TEGs 34.

Together, the frame member 32 and the hot contact surface define an effective surface area. To ensure that the majority of the heat transfer is directly into the TEG 34, the hot contact surface preferably is at least 80% of this effective surface area. More preferably, the hot contact surface may be at least 90% of this effective surface area.

Preferably, the heat exchanger construction 200 is formed mostly of these TEG assemblies 300 as shown in Figure 4 with each TEG assembly 300 forming a defining a wall of the combustion chamber 22. This results in the combustion chamber being at least partially bounded by the hot contact surface of one or more TEGs 34., which at least partially surround the combustion chamber 22.

Of course, a blank panel may be used in the place of one or more of the TEG assemblies 300.

While an octagonal combustion chamber 22 is defined by the present arrangement, it is appreciated that other shapes may also be suitable. In particular, a rectangular combustion chamber 22 is also envisioned. Additionally, non-polygonal shapes are also envisioned, such as a cylindrical combustion chamber 22. This may use TEGs 34 with curved hot contact surfaces to enhance heat absorption.

By having the hot side of the TEG 34 directly forming the wall of the combustion chamber 22, high grade heat is directly used for the generation of electricity, rather than lower grade waste heat later in the cycle. As a result, the electricity generated is actively regulated and not a passive function of waste heat as in some prior art systems.

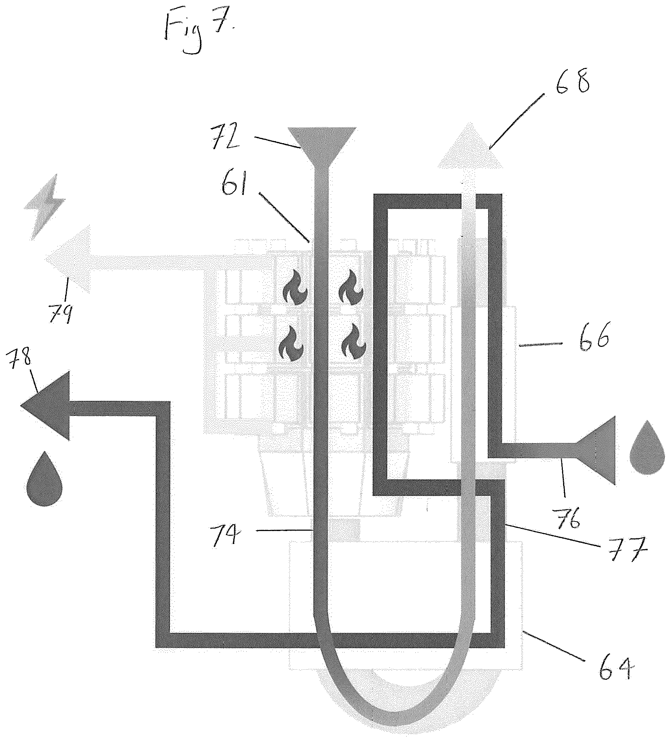

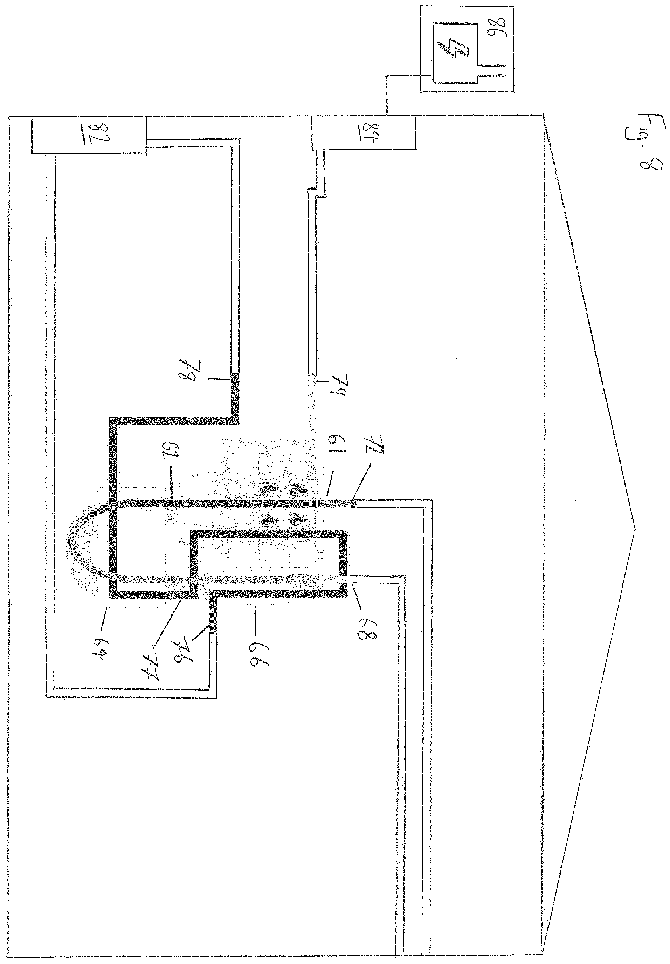

In the present embodiment, the heat sink 36 is an extruded metal component in which water flows (as described in more detail below with respect to Figures 7 and 8 below). However, any other suitable material and fluid combination could be used, for example an oil may be used in place of water. The water used in the heat sinks 36 may be heated to approximately 70°C.

Each heat sink 36 has a cold-side inlet and outlet. A plurality of parallel cold-side lines may be formed, each line serving a plurality of TEGs 34. In the depicted example, each line supplies three horizontally stacked TEGs 34. Each inlet and outlet is offset from the central horizontal axis of the TEGs 34 such that a tortuous (or winding) path is defined.

A standard gas burner 28 is provided within the combustion chamber 22. This is a standard component used in condensing boilers, and delivers thermal power through both thermal radiation and thermal convection. Figure 4 depicts a cylindrical burner 28 which is selected to optimise the system 100 for radiative heat exchange, as opposed to traditional boilers where the dominant mode of heat transfer is convective. Other burner 28 shapes are also suitable for the present invention, including rectangular or octagonal.

As this system 100 is designed to fit within standard condensing boiler cases, this heat exchanger construction must have its dimensions carefully considered. To this end, the combustion chamber 22 and the thermoelectric generator modules 300 define an effective width, formed as the largest distance between points on the periphery, of no more than 450 mm. Preferably, no more than 375 mm, and more preferably no more than 350 mm.

The electricity generated by the TEGs 34 can be measured and used to estimate the temperature of fluids (exhaust gasses/water) within the system 100. This information can be used in a smart control system to maximise the efficiency of the system 100.

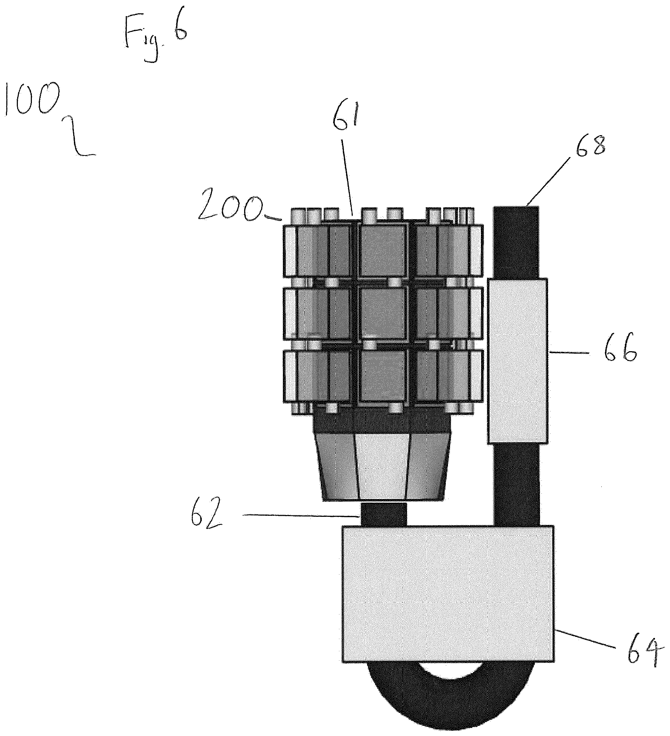

Figure 6 shows the major components of the system 100 when considering the flow of fluids, with the relevant fluid flows in Figure 7. A mixture of natural gas and air 72 is fed into the heat exchanger construction 200 at inlet 61. This mixture is combusted in the heat exchanger construction 200 to generate heat, and exhaust gasses 74 are expelled into exhaust 62.

A medium temperature heat exchanger 64 is provided downstream of this exhaust 62. The expelled exhaust gasses 74 act as the hot side of this heat exchanger 64, with water to be heated acting as the cold side. The water entering the heat exchanger 64 as the cold side has been expelled from the cold side of heat sinks 36 of the TEGs 34 (i.e. from the point of view of the water, this medium temperature heat exchanger 64 is downstream of the cold side of the heat sinks 36 of the TEGs 34).

A condenser 66 is further provided downstream of the medium temperature heat exchanger 64 for the exhaust gasses. A cold water input 76 is provided to supply cold water to be heated to the system 100. This condenser 66 is the first component of the system 100 that the water to be heated passes through.

In alternate systems, not depicted in the Figures, the medium temperature heat exchanger 64 may be omitted. In these systems the output from the heat sinks 36 of the TEGs 34 is routed directly to the hot water outlet 78.

In particular, one such alternate design is for a system optimised for running at full power for a long period of time. This contrasts with the system of the Figures, which is optimised to run at a low power for a long time. In this alternate design, more TEGs 34 are provided and hence less power has to be processed. As a result, the medium heat exchanger 64 may become redundant.

Finally, an exhaust 68 is provided downstream of the condenser for the exhaust gasses, where cold exhaust gas is expelled.

Water to be heated is input into the system at the cold water input 76. From there, it passes through the condenser 66 and into an inlet of the cold side of the heat sinks 36 of the TEGs 34. This provides a first preheating of the water as the heat exchanger construction 200 acts as a high temperature heat exchanger.

The preheated water 77 is then passed into the medium temperature heat exchanger 64, for further heating thereof. This is preferably a counter current heat exchanger as depicted in Figure 7. In systems without a medium temperature heat exchanger 64, this step is omitted.

Hot water is then outputted from the system 100 at hot water output 78. This hot water preferably has maximum thermal output power of between approximately 15 and 30 kW. This maximum output power can then be modulated by the end user, typically to approximately 40% to 60% of the maximum.

The TEG module assemblies 300 are electrically connected to provide an output generated electricity 79. This is preferably in the range of approximately 200 W to 1200 W.A low-power system may produce in the region of approximately 200 W to 400 W, while a high power system may produce in the region of approximately 600 W to 800 W.

Figure 8 shows the whole system 800 of the present invention. The hot water output 78 feeds the hot water demands of the house, such as heating systems 82. The output electricity 79 is connected to the house electrical system 84 supplied to supplement the electricity provided to the house by the traditional power grid 86.

As the system is compact in nature, it is able to fit within a standard boiler housing. This is important as these are typically placed within cupboards and the like where it is not easy to expand the available space without significant work.

To replace a condensing boiler, the installation of the present system is straightforward as many of the existing components and supply lines can be maintained. The system is directly connected to the already installed gas feed line, boiler inlet water line and boiler outlet water line. The exhaust pipe and condensate drainage pipe of the new system can also be the same in terms of typology and dimension (in particular diameter). The only additional modification is that, depending upon the current existent electrical system in the property, a dedicated electric circuit may need to be installed in the new system.

To replace a non-condensing boiler replacement, in addition to the modifications noted above it is also necessary to make the changes needed for the installation of a condensing boiler. In particular, the condensate drain must be set up, and configured to discharge either externally or into waste water pipes. Flue exhaust piping must be checked for suitability, especially if shared with other users. A cleaning of the heating system and hot water piping must also be carried out.

In this manner, a micro cogeneration system can be provided for a domestic environment which can be readily fitted to improve existing boiler systems.

### CLAUSES:

1. A micro cogeneration system, comprising
   a water inlet for receiving cold water;
   a water outlet for outputting hot water;
   a conduit connecting the water inlet and outlet;
   a fuel supply line for supplying combustible fuel;
   a combustion chamber, the combustion chamber surrounding a burner, the burner arranged to burn combustible fuel delivered by the fuel supply line to generate heat for heating water in the conduit;
   a flue passageway arranged to receive heated gas from the combustion chamber
   one or more thermoelectric generator modules arranged to generate electricity from the heat generated in the combustion chamber, comprising a hot side with a hot contact surface arranged to receive heat from the combustion chamber, and a cold side with a cold contact surface arranged to transfer heat to a first section of the conduit; and
   a heat exchanger arranged to transfer heat from the flue passageway to a second section of the conduit, the second section of the conduit being downstream of the first section of the conduit.
2. The micro cogeneration system of clause 1, wherein the or each thermoelectric generator modules comprise a heat sink for transferring heat to the first section of the conduit.
3. The micro cogeneration system of clause 2, wherein the system comprises a first plurality of thermoelectric generator modules, and the heat sinks of each of the first plurality of thermoelectric generator modules are fluidly connected to form a heat sink conduit for flow of a fluid medium.
4. The micro cogeneration system of clause 3, wherein the heat sink conduit forms a tortuous pathway.
5. The micro cogeneration system of clauses 3 or 4, wherein the first plurality of thermoelectric generator modules is arranged in a substantially vertical stack in use.
6. The micro cogeneration system of any of clauses 3 to 5, wherein the system further comprises a second plurality of thermoelectric generator modules, and the heat sinks of each of the second plurality of thermoelectric generator modules are fluidly connected to form a second conduit for flow of a fluid medium in parallel to the first conduit.
7. The micro cogeneration system of clause 6, wherein the second conduit forms a tortuous pathway.
8. The micro cogeneration system of clauses 6 or 7, wherein the second plurality of thermoelectric generator modules is arranged in a substantially vertical stack in use.
9. The micro cogeneration system of any preceding clause, wherein the combustion chamber is at least partially bounded by the hot contact surface of one or more of the thermoelectric generator modules.
10. The micro cogeneration system of any preceding clause, further comprising one or more frames for supporting one or more thermoelectric generator modules.
11. The micro cogeneration system of clause 10, wherein each thermoelectric generator module comprises a frame for attaching to a further thermoelectric generator module.
12. The micro cogeneration system of clause 10, wherein a single frame is provided onto which each thermoelectric generator module is attached.
13. The micro cogeneration system of any of clauses 10 to 12, wherein the frame is substantially on the hot side of the thermoelectric generator module.
14. The micro cogeneration system of clause 13 wherein the frame surrounds or overlays a periphery of the hot contact surface.
15. The micro cogeneration system of clause 14, wherein the frame and the hot contact surface collectively define a hot side surface area, and the hot contact surface is at least 80% of this surface area.
16. The micro cogeneration system of any preceding clause, wherein the burner is a cylindrical burner configured to optimise the system for radiative heat exchange.
17. The micro cogeneration system of any preceding clause, further comprising a control system in electrical connection with the one or more thermoelectric generator modules for measuring characteristics of electricity generated by the one or more thermoelectric generator modules, wherein the control system is configured to use these characteristics to determine properties of one or more of: exhaust flue gasses; a fluid coolant medium, wherein the properties include temperature.
18. The micro cogeneration system of any preceding clause, wherein the heat exchanger is a counter-currant heat exchanger.
19. The micro cogeneration system of any preceding clause, further comprising a condenser upstream of the first section of the conduit for condensing water entering the system, the condenser being downstream of the flue passageway for the flue gas.
20. A micro cogeneration system, comprising:
   a housing
   a water inlet into the housing for receiving cold water;
   a water outlet from the housing for outputting hot water;
   a conduit within the housing connecting the water inlet and outlet;
   a fuel supply line for supplying combustible fuel;
   a combustion chamber within the housing, the combustion chamber surrounding a burner, the burner arranged to burn combustible fuel delivered by the fuel supply line to generate heat for heating water in the conduit;
   one or more thermoelectric generator modules comprising:
      a heat sink; and
      a thermoelectric generator having a hot side having a hot contact surface arranged to receive heat from the combustion chamber, and a cold side having a
   cold contact surface arranged to transfer heat to the heat sink,
   wherein the combustion chamber and thermoelectric generator modules have a combined effective width, which is less than 450 mm.
21. The micro cogeneration system of clause 20, wherein the combustion chamber and thermoelectric generator modules have a combined effective width of no more than 375 mm, and more preferably no more than 350 mm.
22. A method of replacing a condensing boiler comprising a condenser and a boiler housing, with a micro cogeneration system, the method comprising the steps of:
   removing the combustion chamber of the condensing boiler;
   installing within the boiler housing a replacement combustion chamber, with one or more thermoelectric generator modules arranged to generate electricity from the heat generated in the replacement combustion chamber, comprising a hot side with a hot contact surface arranged to receive heat from the replacement combustion chamber, and a cold side with a cold contact surface; and
   re-routing a water outlet of the condenser to pass through one or more conduits arranged to receive heat from the cold contact surface of the one or more thermoelectric generator modules.
23. A method of replacing a non-condensing boiler comprising a boiler housing, with a micro cogeneration system, the method comprising the steps of:
   removing the combustion chamber of the non-condensing boiler;
   installing within the boiler housing a replacement combustion chamber, with one or more thermoelectric generator modules arranged to generate electricity from the heat generated in the replacement combustion chamber, comprising a hot side with a hot contact surface arranged to receive heat from the replacement combustion chamber, and a cold side with a cold contact surface;
   installing a condenser to transfer heat from flue gasses to a water inlet to the boiler;
   installing a condensate drain configured to discharge condensate; and
   routing a water outlet of the condenser to pass through one or more conduits arranged to receive heat from the cold contact surface of the one or more thermoelectric generator modules.
24. The method of clause 22 or 23, further comprising the step of installing a dedicated electric circuit configured to receive electricity from the one or more thermoelectric generator modules.

## Claims

1. A micro cogeneration system, comprising
a water inlet for receiving cold water;
a water outlet for outputting hot water;
a conduit connecting the water inlet and outlet;
a fuel supply line for supplying combustible fuel;
a combustion chamber, the combustion chamber surrounding a burner, the burner arranged to burn combustible fuel delivered by the fuel supply line to generate heat for heating water in the conduit;
a flue passageway arranged to receive heated gas from the combustion chamber;
one or more thermoelectric generator modules arranged to generate electricity from the heat generated in the combustion chamber, comprising a hot side with a hot contact surface arranged to receive heat from the combustion chamber, and a cold side with a cold contact surface arranged to transfer heat to a first section of the conduit; and
a heat exchanger arranged to transfer heat from the flue passageway to a second section of the conduit, the second section of the conduit being downstream of the first section of the conduit.

2. The micro cogeneration system of claim 1, wherein the or each thermoelectric generator modules comprise a heat sink for transferring heat to the first section of the conduit, preferably the system comprises a first plurality of thermoelectric generator modules, and the heat sinks of each of the first plurality of thermoelectric generator modules are fluidly connected to form a heat sink conduit for flow of a fluid medium, more preferably the heat sink conduit forms a tortuous pathway.

3. The micro cogeneration system of claim2, comprises a first plurality of thermoelectric generator modules arranged in a substantially vertical stack in use.

4. The micro cogeneration system of any of claims 2 to 3, wherein the system further comprises a second plurality of thermoelectric generator modules, and the heat sinks of each of the second plurality of thermoelectric generator modules are fluidly connected to form a second conduit for flow of a fluid medium in parallel to the first conduit,
preferably:
the second conduit forms a tortuous pathway; and/or
the second plurality of thermoelectric generator modules is arranged in a substantially vertical stack in use.

5. The micro cogeneration system of any preceding claim, wherein the combustion chamber is at least partially bounded by the hot contact surface of one or more of the thermoelectric generator modules.

6. The micro cogeneration system of any preceding claim, further comprising one or more frames for supporting one or more thermoelectric generator modules,
preferably:
each thermoelectric generator module comprises a frame for attaching to a further thermoelectric generator module; or
a single frame is provided onto which each thermoelectric generator module is attached.

7. The micro cogeneration system of claim 6, wherein the frame is substantially on the hot side of the thermoelectric generator module, preferably the frame surrounds or overlays a periphery of the hot contact surface, more preferably the frame and the hot contact surface collectively define a hot side surface area, and the hot contact surface is at least 80% of this surface area.

8. The micro cogeneration system of any preceding claim, further comprising a control system in electrical connection with the one or more thermoelectric generator modules for measuring characteristics of electricity generated by the one or more thermoelectric generator modules, wherein the control system is configured to use these characteristics to determine properties of one or more of: exhaust flue gasses; a fluid coolant medium, wherein the properties include temperature.

9. The micro cogeneration system of any preceding claim, wherein the heat exchanger is a counter-current heat exchanger.

10. The micro cogeneration system of any preceding claim, further comprising a condenser upstream of the first section of the conduit for condensing water entering the system, the condenser being downstream of the flue passageway for the flue gas.

11. A micro cogeneration system, comprising:
a housing
a water inlet into the housing for receiving cold water;
a water outlet from the housing for outputting hot water;
a conduit within the housing connecting the water inlet and outlet;
a fuel supply line for supplying combustible fuel;
a combustion chamber within the housing, the combustion chamber surrounding a burner, the burner arranged to burn combustible fuel delivered by the fuel supply line to generate heat for heating water in the conduit;
one or more thermoelectric generator modules comprising:
a heat sink; and
a thermoelectric generator having a hot side having a hot contact surface arranged to receive heat from the combustion chamber, and a cold side having a
cold contact surface arranged to transfer heat to the heat sink,
wherein the combustion chamber and thermoelectric generator modules have a combined effective width, which is less than 450 mm.

12. The micro cogeneration system of claim 11, wherein the combustion chamber and thermoelectric generator modules have a combined effective width of no more than 375 mm, and more preferably no more than 350 mm.

13. A method of replacing a condensing boiler comprising a condenser and a boiler housing, with a micro cogeneration system, the method comprising the steps of:
removing a combustion chamber of the condensing boiler;
installing within the boiler housing a replacement combustion chamber, with one or more thermoelectric generator modules arranged to generate electricity from the heat generated in the replacement combustion chamber, comprising a hot side with a hot contact surface arranged to receive heat from the replacement combustion chamber, and a cold side with a cold contact surface; and
re-routing a water outlet of the condenser to pass through one or more conduits arranged to receive heat from the cold contact surface of the one or more thermoelectric generator modules.

14. A method of replacing a non-condensing boiler comprising a boiler housing, with a micro cogeneration system, the method comprising the steps of:
removing a combustion chamber of the non-condensing boiler;
installing within the boiler housing a replacement combustion chamber, with one or more thermoelectric generator modules arranged to generate electricity from the heat generated in the replacement combustion chamber, comprising a hot side with a hot contact surface arranged to receive heat from the replacement combustion chamber, and a cold side with a cold contact surface;
installing a condenser to transfer heat from flue gasses to a water inlet to the boiler;
installing a condensate drain configured to discharge condensate; and
routing a water outlet of the condenser to pass through one or more conduits arranged to receive heat from the cold contact surface of the one or more thermoelectric generator modules.

15. The method of claim 13 or 14, further comprising the step of installing a dedicated electric circuit configured to receive electricity from the one or more thermoelectric generator modules.
